# EUROPÄISCHE PATENTSCHRIFT

(11) **EP 2 040 344 B1**
(45) Veröffentlichungstag und Bekanntmachung des Hinweises auf die Patenterteilung: **20.05.2015**
(21) Anmeldenummer: 08162321.7
(22) Anmeldetag: 13.08.2008
(51) Int. Cl.: H01S 5/042, H01S 5/0687

(54) **Schaltungsanordnung zum Betrieb einer Pulslaserdiode und Verfahren zum Betrieb einer Pulslaserdiode**
Switching device for operating a pulse laser diode and method for operating a pulse laser diode
Dispositif de commutation destiné au fonctionnement d'une diode laser à impulsions et procédé de fonctionnement d'une diode laser à impulsions

(30) Priorität: 18.09.2007 DE 102007044438
(43) Veröffentlichungstag der Anmeldung: 25.03.2009
(73) Patentinhaber: OSRAM Opto Semiconductors GmbH, 93055 Regensburg (DE)
(72) Erfinder: Morgott, Stefan, 93080 Pentling (DE); Behringer, Martin Rudolf, 93051 Regensburg (DE); Maric, Josip, 93161 Sinzing (DE)
(74) Vertreter: Epping - Hermann - Fischer

(56) Entgegenhaltungen:
- EP-A1- 0 957 596
- WO-A1-93/18563
- DE-A1- 3 005 645
- GB-A- 2 224 374
- JP-A- 3 283 585
- US-A- 5 400 351
- US-A1- 2005 117 616
- US-A1- 2005 199 890
- US-A1- 2006 045 145

## Beschreibung

Die Erfindung betrifft eine Schaltungsanordnung zum Betrieb eine Pulslaserdiode, wobei die Pulslaserdiode mit Strom versorgt wird. Darüber hinaus betrifft die Erfindung auch ein Verfahren zum Betrieb der Pulslaserdiode.

Die Druckschriften US 5 400 351, DE 30 05 645 A1, US 2005/0117616 A1, JP 03 283 585, WO 93/18563, EP 0 957 596, GB 2 224 374 und US 2005/0199890 zeigen Schaltungsanordnungen.

Eine Vorrichtung mit einem strahlungsemittierenden Halbleiterbauelement, wobei dem Halbleiterbauelement mindestens ein elektrisches Heizelement zugeordnet ist, ist aus der Druckschrift DE 10 2005 004 145 A1 bekannt.

Eine zu lösende Aufgabe besteht darin, eine Schaltungsanordnung zum Betrieb einer Pulslaserdiode anzugeben, mittels derer eine Pulslaserdiode möglichst stabil betrieben werden kann.

Es wird eine Schaltungsanordnung zum Betrieb einer Pulslaserdiode angegeben, die eine Pulslaserdiode umfasst. Darüber hinaus ist eine Stromquelle vorgesehen, die geeignet ist, einen Gleichstrom in die Pulslaserdiode einzuspeisen.

Mittels des eingespeisten Gleichstroms kann die Temperatur des Chips der Laserdiode beeinflusst werden. Dadurch kann die Temperatur innerhalb gewisser Grenzen gesteuert werden.

In einer bevorzugten Ausführungsform der Schaltungsanordnung ist ein Mittel vorgesehen, das der Begrenzung des in die Pulslaserdiode eingespeisten Stroms dient. Vorzugsweise wird der Strom auf einen Wert begrenzt, der kleiner ist als die Laserschwelle der Pulslaserdiode.

Dies hat den Vorteil, dass der eingespeiste Gleichstrom die Erzeugung der Strahlung der Pulslaserdiode nicht beeinflusst, da der Wert unterhalb der Laserschwelle der Pulslaserdiode liegt. Dadurch kann erreicht werden, dass mittels von der Stromquelle unabhängigen Mitteln der strahlungsmäßige Betrieb der Pulslaserdiode gewährleistet werden kann. Der Gleichstrom wird somit nicht zum Pumpen der Pulslaserdiode verwendet.

Daraus ergibt sich des Weiteren der Vorteil, dass die Energie des eingespeisten Gleichstroms zu einem großen Teil zur Erzeugung von Wärme innerhalb der Pulslaserdiode zur Verfügung steht. Dadurch kann kontrolliert Wärme in der Pulslaserdiode bzw. im Chip der Pulslaserdiode erzeugt werden, womit gleichzeitig die Temperatur der Pulslaserdiode beeinflusst werden kann.

Die Beeinflussung der Temperatur der Pulslaserdiode hat den Vorteil, dass unter Verwendung geeigneter weiterer Mittel, die im Folgenden beschrieben sind, die Temperatur innerhalb gewisser Grenzen gehalten werden kann. Dadurch kann ein unkontrolliertes und unbeabsichtigtes Abdriften der Temperatur der Pulslaserdiode verhindert werden. Damit kann erreicht werden, dass die Pulswellenlänge, bei der die Pulslaserdiode ihre Strahlung emittiert, innerhalb gewisser Grenzen stabil gehalten werden kann. Vorzugsweise werden nämlich in der Schaltungsanordnung Pulslaserdioden verwendet, deren Peak-Wellenlänge der emittierten Strahlung von der Temperatur des Chips der Pulslaserdiode abhängig ist.

Beispielsweise können Pulslaserdioden verwendet werden, deren Emissionswellenlänge bzw. Pulswellenlänge pro Kelvin Temperaturunterschied sich um +0,3 nm ändert.

Dies ermöglicht den Einsatz der Pulslaserdiode insbesondere in Automobilanwendungen, wo sie in Sensoren zur Abstandsmessung eingesetzt werden. Indem die Pulswellenlänge der Pulslaserdiode möglichst konstant gehalten wird, kann der Empfänger des von der Pulslaserdiode abgestrahlten Lichts stets in einem guten bzw. sogar stets im optimalen Arbeitspunkt arbeiten.

Darüber hinaus ermöglicht der Einsatz der hier beschriebenen Pulslaserdiode zusammen mit der zugehörigen Schaltungsanordnung den Einsatz von schmalbandigen Filtern vor dem Empfänger bzw. Detektor, womit Umgebungs- oder auch Störlicht sehr gut unterdrückt werden kann und womit zugleich auch das Verhältnis von Signal-zu-Rauschen hoch gehalten werden kann.

Gemäß einer Ausführungsform der Schaltungsanordnung zum Betrieb einer Pulslaserdiode ist die Stromquelle geeignet, einen Strom in die Diode einzuspeisen, der ausreicht, um die Temperatur im Chip der Diode um wenigstens 10 K zu erhöhen.

Dadurch ergibt sich der Vorteil, dass die Temperatur der Pulslaserdiode in einem signifikanten Bereich variiert werden kann, wodurch sich erweiterte Steuerungsmöglichkeiten ergeben.

Gemäß einer Ausführungsform ist es zudem vorgesehen, dass eine Messvorrichtung von der Schaltungsanordnung umfasst ist, die zur Ermittlung der Temperatur der Pulslaserdiode vorgesehen ist. Mittels einer solchen Messvorrichtung kann bei der geeigneten Wahl einer Stromquelle eine Steuerung der Temperatur der Pulslaserdiode erfolgen, was beispielsweise dazu benutzt werden kann, die Temperatur der Pulslaserdiode und damit die Peak-Wellenlänge des von der Pulslaserdiode abgestrahlten Lichts möglichst konstant zu halten.

Zu diesem Zweck wird gemäß einer Ausführungsform der Schaltungsanordnung die Messvorrichtung an die Stromquelle gekoppelt, wobei der in die Pulslaserdiode eingespeiste Strom durch ein elektrisches Signal steuerbar ist. Vorzugsweise erfolgt die Steuerung des in die Pulslaserdiode eingespeisten Stroms durch ein Signal, das von der gemessenen Temperatur der Pulslaserdiode abhängt.

Darüber hinaus wird ein Verfahren zum Betrieb einer Pulslaserdiode angegeben, wobei ein Gleichstrom in die Pulslaserdiode eingespeist wird zur Anpassung deren Temperatur an einen vorgegebenen Wert.

Ein solches Verfahren kann beispielsweise mittels der hier beschriebenen Schaltungsanordnung durchgeführt werden.

Besonders vorteilhaft wird beim Verfahren zum Betrieb einer Pulslaserdiode die Temperatur der Pulslaserdiode mittels einer geeigneten Regelvorrichtung konstant gehalten.

Es wird darüber hinaus ein Verfahren zum Betrieb einer Pulslaserdiode angegeben, wobei die Pulswellenlänge der Pulslaserdiode durch das Einspeisen eines Gleichstroms in die Pulslaserdiode gesteuert wird.

Dies hat den Vorteil, dass durch das Einspeisen des Stroms in die Pulslaserdiode und die damit verbundene Erwärmung der Pulslaserdiode mit einfachen Mitteln die Wellenlänge des von der Pulslaserdiode abgestrahlten Lichts gesteuert werden kann.

Insbesondere kann die Temperatur der Pulslaserdiode durch die Höhe des Gleichstroms eingestellt werden, da mit dem eingespeisten Strom auch die Temperatur der Pulslaserdiode ansteigt.

Gemäß einer Ausführungsform der Schaltungsanordnung bzw. des Verfahrens zum Betrieb der Pulslaserdiode wird der eingespeiste Strom konstant gehalten, um die Pulslaserdiode zu heizen und auf einer konstanten Temperatur zu halten, unabhängig davon, wie sich die äußere Temperatur in der Umgebung entwickelt.

Im Folgenden wird die Schaltungsanordnung zum Betrieb einer Pulslaserdiode sowie das Verfahren zum Betrieb einer Pulslaserdiode anhand von Ausführungsbeispielen und den dazu gehörigen Figuren näher erläutert.

Dabei sind die Figuren nicht als maßstabsgetreu aufzufassen; vielmehr können einzelne Dimensionen aus Gründen der verbesserten Darstellung verlängert oder verkürzt oder auch verzerrt dargestellt sein. Elemente, die die gleiche Funktion ausüben, sind mit den gleichen Bezugszeichen bezeichnet.
- Figur 1: zeigt schematisch eine Schaltungsanordnung zum Betrieb einer Pulslaserdiode.
- Figur 2: zeigt die von der Pulslaserdiode abgestrahlte Strahlung in Abhängigkeit von dem in die Pulslaserdiode eingespeisten Gleichstrom.
- Figur 3: zeigt die Abhängigkeit der Wellenlängenverschiebung und die Abhängigkeit der Temperaturänderung der Pulslaserdiode in Abhängigkeit vom eingespeisten Gleichstrom.
- Figur 4: zeigt die optische Leistung der Pulslaserdiode in Abhängigkeit von der Temperaturänderung der Pulslaserdiode.

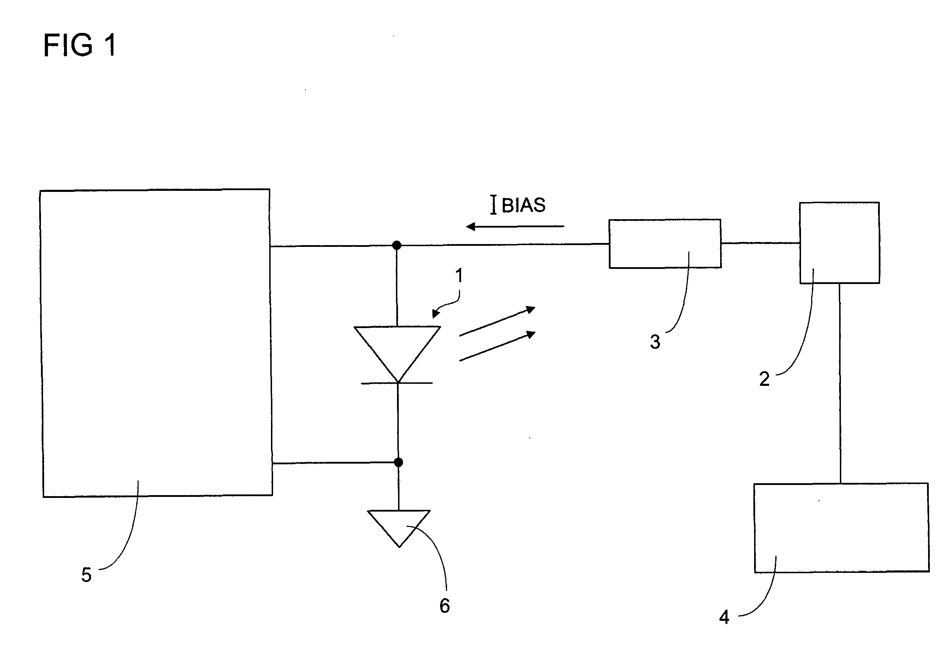

Figur 1 zeigt eine Schaltungsanordnung zum Betrieb einer Pulslaserdiode, wobei eine Pulslaserdiode 1 vorgesehen ist. Zum Betrieb der Pulslaserdiode wird eine Pulser-Schaltung 5 verwendet. In dem in Figur 1 gezeigten Ausführungsbeispiel handelt es sich bei der Pulslaserdiode um das Modell SPL PL90.

Die Pulser-Schaltung ist so ausgelegt, dass sie einen Strom von 30 A in die Pulslaserdiode 1 einspeisen kann. Die Strompulse haben dabei eine Pulsdauer von 100 ns und werden mit einer Frequenz von 1 kHz in die Pulslaserdiode 1 eingespeist.

Darüber hinaus ist eine Gleichstromquelle 2 vorgesehen, die einen Gleichstrom in die Pulslaserdiode 1 einspeist. Dabei fließt der Gleichstrom bevorzugt über ein Mittel zur Strombegrenzung 3, welches beispielsweise ein ohmscher Widerstand sein kann. In dem Beispiel von Figur 1 wird als Strombegrenzung 3 ein Widerstand von 100 Ω verwendet. Die Stromquelle im Beispiel von Figur 1 liefert eine Versorgungsspannung zwischen 0 V und 16,5 V, was bei einem Widerstand von 100 Ω zu einem Gleichstrom von zwischen 0 und 150 mA führt, der über die Stromquelle 2, die Strombegrenzung 3, die Laserdiode 1 schließlich bis zum Masseanschluss 6 fließt.

Darüber hinaus ist eine Temperaturmessvorrichtung 4 vorgesehen, die beispielsweise mittels einer elektrischen Leitung mit der Stromquelle gekoppelt sein kann.

Die von der Temperaturmessvorrichtung 4 gelieferten Messwerte betreffend die Temperatur der Pulslaserdiode 1 können zur Steuerung der Stromquelle 2 verwendet werden.

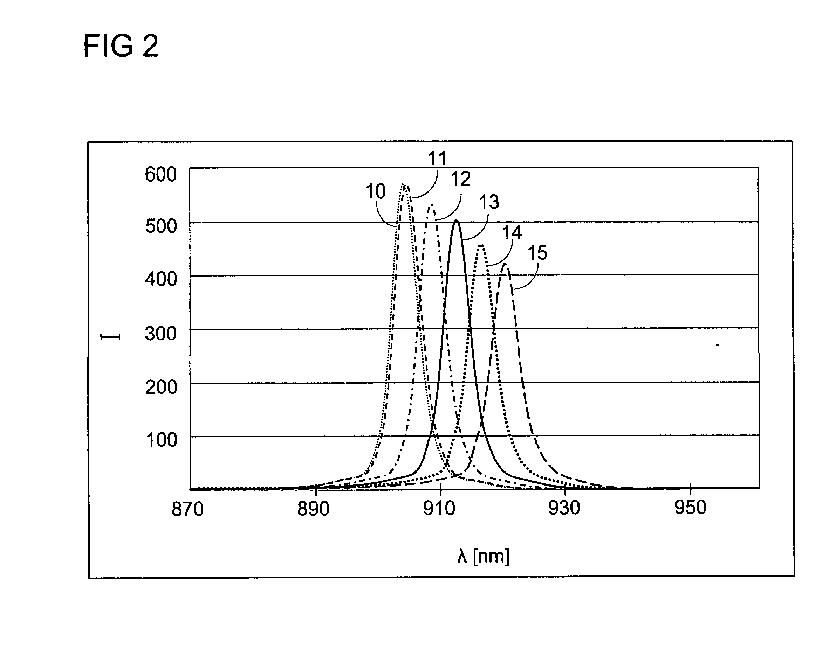

Figur 2 zeigt die in einer Anordnung nach Figur 1 gemessene optische Intensität der Pulslaserdiode in Abhängigkeit von der Wellenlänge λ des von der Laserdiode abgestrahlten Lichts für verschiedene Gleichströme, die in die Pulslaserdiode eingespeist werden.

Dabei zeigt die Kurve 10 die optische Intensität I in Abhängigkeit von der Wellenlänge λ für einen Gleichstrom von 0 mA. Die Kurve 11 zeigt die Intensität für einen Gleichstrom von 30 mA. Die Kurve 12 zeigt die Intensität für einen Gleichstrom von 60 mA. Die Kurve 13 zeigt die Intensität für einen Gleichstrom von 90 mA. Die Kurve 14 zeigt die Intensität für einen Gleichstrom von 120 mA. Die Kurve 15 zeigt die Intensität für einen Gleichstrom von 150 mA.

Aus der Figur 2 geht hervor, dass eine signifikante Verschiebung des von der Pulslaserdiode emittierten Strahlungspulses entlang der Wellenlängenachse möglich ist.

Damit ist gezeigt, dass durch den Einsatz der hier beschriebenen Schaltungsanordnung die Wellenlänge der Pulslaserdiode durch die Stromquelle gesteuert werden kann.

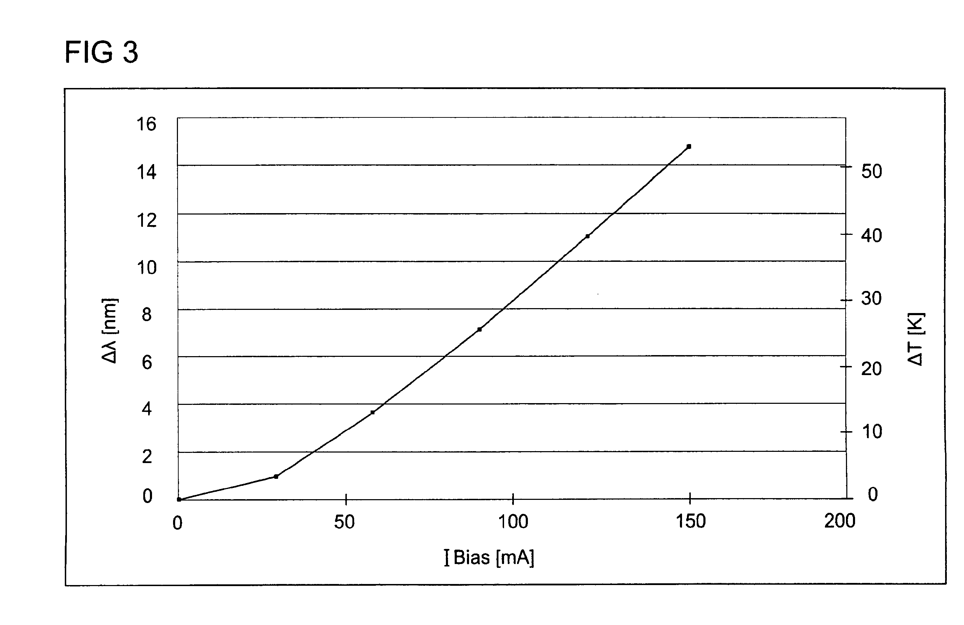

Figur 3 zeigt die Änderung der Pulswellenlänge, wie sie in Figur 2 gezeigt wird, in Abhängigkeit von dem eingespeisten Gleichstrom. Darüber hinaus zeigt Figur 3 die Änderung der Temperatur ΔT in Abhängigkeit vom eingespeisten Gleichstrom IBIAS.

Figur 3 ist zu entnehmen, dass zumindest ab einem eingespeisten Strom von etwa 50 mA ein nahezu proportionaler Zusammenhang zwischen dem eingespeisten Gleichstrom und der Wellenlängenänderung Δλ einerseits und dem eingespeisten Gleichstrom IBIAS und der Temperaturänderung ΔT andererseits herrscht. Dies zeigt, daß die Steuerung der Wellenlänge des abgestrahlten Lichts sowie die Steuerung der Temperatur der Pulslaserdiode sehr einfach und ohne großen Schaltungs- bzw. Rechenaufwand möglich ist.

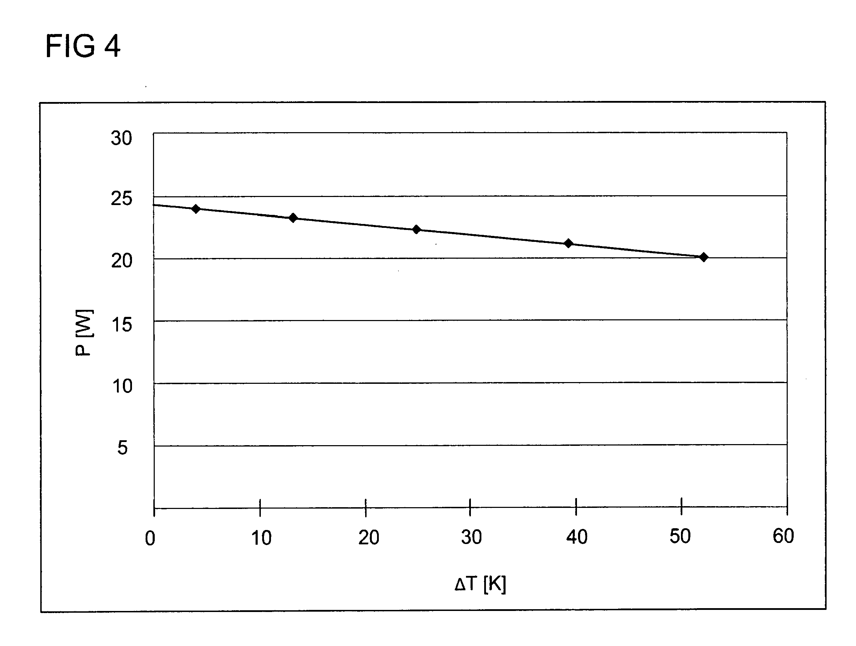

Figur 4 zeigt die Abhängigkeit der optischen Leistung P der Pulslaserdiode in Abhängigkeit von der Temperaturerhöhung ΔT der Pulslaserdiode. Auch hier ergibt sich ein linearer Zusammenhang, wobei mit einer Steigerung von -0,08 W/K eine sehr geringe Abhängigkeit der optischen Leistung von der Temperaturerhöhung feststellbar ist. Dadurch ist gezeigt, dass der Betrieb einer Pulslaserdiode bei erhöhter Temperatur sehr stabil und ohne größere Verluste hinsichtlich der optischen Leistung P möglich ist.

## Patentansprüche

1. Schaltungsanordnung zum Betrieb einer Pulslaserdiode (1), aufweisend
- eine Pulslaserdiode (1);
- eine Pulser-Schaltung (5), welche einen Strom in die Pulslaserdiode (1) einspeist;
- eine Gleichstromquelle (2), die einen Gleichstrom IBIAS in die Pulslaserdiode (1) einspeist;
- eine Temperaturmessvorrichtung (4) zur Ermittlung von Messwerten betreffend die Temperatur der Pulslaserdiode (1), die mittels einer elektrischen Leitung mit der Gleichstromquelle (2) gekoppelt ist, **dadurch gekennzeichnet, dass** die Schaltungsanordnung so konfigueriert ist, daß
die von der Temperaturmessvorrichtung (4) gelieferten Messwerte betreffend die Temperatur der Pulslaserdiode (1) zur Steuerung der Gleichstromquelle (2) verwendet werden, und die Gleichstromquelle (2) einen Strom in die Pulslaserdiode (1) einspeist, der ausreicht, um die Temperatur im Chip der Pulslaserdiode (1) im Betrieb um wenigstens 10 K zu erhöhen.

2. Anordnung nach Anspruch 1,
wobei eine Strombegrenzung (3) vorgesehen ist zur Begrenzung des eingespeisten Gleichstroms IBIAS auf einen Wert, der kleiner ist als die Laserschwelle der Pulslaserdiode (1).

3. Verfahren zum Betrieb einer Pulslaserdiode (1),
bei dem die Pulswellenlänge λ der Pulslaserdiode (1) durch Einspeisen eines Gleichstroms IBIAS in die Pulslaserdiode (1) gesteuert wird,
- eine Pulser-Schaltung (5) einen Strom in die Pulslaserdiode (1) einspeist,
- eine Gleichstromquelle (2) einen Gleichstrom in die Pulslaserdiode (1) einspeist,
- mittels einer elektrischen Leitung eine Temperaturmessvorrichtung (4) mit der Gleichstromquelle (2) gekoppelt ist, **dadurch gekennzeichnet, dass**
die von der Temperaturmessvorrichtung (4) gelieferten Messwerte betreffend die Temperatur der Pulslaserdiode (1) zur Steuerung der Gleichstromquelle (2) verwendet werden, und die Gleichstromquelle (2) einen Strom in die Pulslaserdiode (1) einspeist, der ausreicht, um die Temperatur im Chip der Laserdiode (1) um wenigstens 10 K zu erhöhen.

4. Verfahren nach Anspruch 3,
wobei der Strom mit einer Stromstärke von wenigstens 30 mA und höchstens 150 mA eingespeist wird.

## Claims

1. Circuit arrangement for operating a pulse laser diode (1), comprising
- a pulse laser diode (1);
- a pulser circuit (5), which feeds a current into the pulse laser diode (1);
- a DC current source (2), which feeds a DC current IBIAS into the pulse laser diode (1);
- a temperature measuring device (4) for determining measurement values concerning the temperature of the pulse laser diode (1), which is coupled to the DC current source (2) by means of an electrical line, **characterized in that** the circuit arrangement is configured such that
the measurement values concerning the temperature of the pulse laser diode (1) that are supplied by the temperature measuring device (4) are used for controlling the DC current source (2) and the DC current source (2) feeds into the pulse laser diode (1) a current that suffices to increase the temperature in the chip of the pulse laser diode (1) during operation by at least 10 K.

2. Arrangement according to Claim 1, wherein a current limiting system (3) is provided for limiting the fed-in DC current IBIAS to a value that is less than the laser threshold of the pulse laser diode (1).

3. Method for operating a pulse laser diode (1),
wherein the pulse wavelength λ of the pulse laser diode (1) is controlled by a DC current IBIAS being fed into the pulse laser diode (1),
- a pulser circuit (5) feeds a current into the pulse laser diode (1)
- a DC current source (2) feeds a DC current into the pulse laser diode (1),
- a temperature measuring device (4) is coupled to the DC current source (2) by means of an electrical line, **characterized in that** the measurement values concerning the temperature of the pulse laser diode (1) that are supplied by the temperature measuring device (4) are used for controlling the DC current source (2) and the DC current source (2) feeds into the pulse laser diode (1) a current that suffices to increase the temperature in the chip of the laser diode (1) by at least 10 K.

4. Method according to Claim 3,
wherein the current is fed in with a current intensity of at least 30 mA and at most 150 mA.

## Revendications

1. Agencement de commutation destiné au fonctionnement d'une diode laser à impulsions (1), comportant :
- une diode laser à impulsions (1) ;
- un circuit impulseur (5) amenant un courant dans la diode laser à impulsions (1) ;
- une source de courant continu (2) amenant un courant continu IBIAS dans la diode laser à impulsions (1) ;
- un dispositif de mesure de température (4) permettant de calculer des valeurs de mesure concernant la température de la diode laser à impulsions (1) couplée à la source de courant continu (2) au moyen d'un câble électrique ;
**caractérisé en ce que** l'agencement de commutation est configuré de telle sorte que les valeurs de mesure concernant la température de la diode laser à impulsions (1) fournies par le dispositif de mesure de température (4) sont utilisées pour commander la source de courant continu (2) et que la source de courant continu (2) amène un courant dans la diode laser à impulsions (1) suffisant pour accroître en fonctionnement la température dans la puce de la diode laser à impulsions (1) d'au moins 10 K.

2. Agencement selon la revendication 1, une limitation de courant (3) étant prévue pour limiter le courant continu IBIAS amené à une valeur inférieure au seuil de laser de la diode laser à impulsions (1).

3. Procédé destiné au fonctionnement d'une diode laser à impulsions (1), dans lequel la longueur d'onde d'impulsion λ de la diode laser à impulsions (1) est commandée par amenée d'un courant continu IBIAS dans la diode laser à impulsions (1) ;
- un circuit impulseur (5) amène un courant dans la diode laser à impulsions (1) ;
- une source de courant continu (2) amène un courant continu dans la diode laser à impulsions (1) ;
- un dispositif de mesure de température (4) est couplé à la source de courant continu (2) au moyen d'un câble électrique ;
**caractérisé en ce que** les valeurs de mesure concernant la température de la diode laser à impulsions (1) fournies par le dispositif de mesure de température (4) sont utilisées pour commander la source de courant continu (2) et que la source de courant continu (2) amène un courant dans la diode laser à impulsions (1) suffisant pour accroître la température dans la diode à laser (1) d'au moins 10 K.

4. Procédé selon la revendication 3, le courant étant amené à une intensité de courant d'au moins 30 mA et tout au plus de 150 mA.
